# EUROPEAN PATENT SPECIFICATION

(11) **EP 3 322 263 B1**
(45) Date of publication and mention of the grant of the patent: **25.03.2020**
(21) Application number: 17200087.9
(22) Date of filing: 06.11.2017
(51) Int. Cl.: H05H 1/46

(54) **COAXIAL-CABLE COUPLED AND WATER-COOLED SWP (SURFACE WAVE PLASMA) GENERATOR**
KOAXIALKABEL-GEKOPPELTER UND WASSERGEKÜHLTER SWP (OBERFLÄCHENWELLENPLASMA)-GENERATOR
GÉNÉRATEUR DE SWP (PLASMA À ONDES DE SURFACE) COUPLÉ ET REFROIDI PAR EAU À CÂBLE COAXIAL

(30) Priority: 11.11.2016 KR 20160150205
(43) Date of publication of application: 16.05.2018
(73) Proprietor: Korea Basic Science Institute, Daejeon 305-806 (KR)
(72) Inventor: YOU, Hyun Jong, Sejong-si (KR)
(74) Representative: Laine IP Oy

(56) References cited:
- WO-A1-2014/009412
- US-A- 4 810 933
- US-A1- 2006 071 607
- US-A1- 2010 301 012

## Description

### CROSS-REFERENCE TO RELATED APPLICATION

This application claims the benefit of Korean patent application No. 10-2016-0150205 filed on 11.11.2016.

### BACKGROUND

### Field of the Present Disclosure

The present invention relates to a surface wave plasma SWP generator and more particularly to a coaxial-cable coupled and water-cooled SWP (surface wave plasma) generator.

### Discussion of Related Art

Surface wave plasma SWP is generated by a surface wave being propagated to an interface between the plasma and the dielectric. The surface wave plasma enables dense plasma. In this surface wave plasma approach, an electromagnetic wave generator applicator or an antenna is located outside a plasma chamber. Therefore, the surface wave plasma approach may lead to a very simple, efficient and flexible configuration as compared to the conventional RF plasma approach. Further, the SWP approach may operate in a very wide pressure range from tens of mTorr to an atmospheric pressure. The SWP plasma density may range from about 10⁸ - 10¹⁵ cm⁻³. The SWP also has a higher electron temperature and thus is more efficient in molecular dissociation and radical generation than in the conventional DC/RF approach. As a result, the surface wave plasma may be widely applied to semiconductor processing fields such as remote cleaning, radical generation, decomposition/reduction of greenhouse gases SF₆, CF₄, PFC, etc., semiconductor passivation, and film removal, etc.

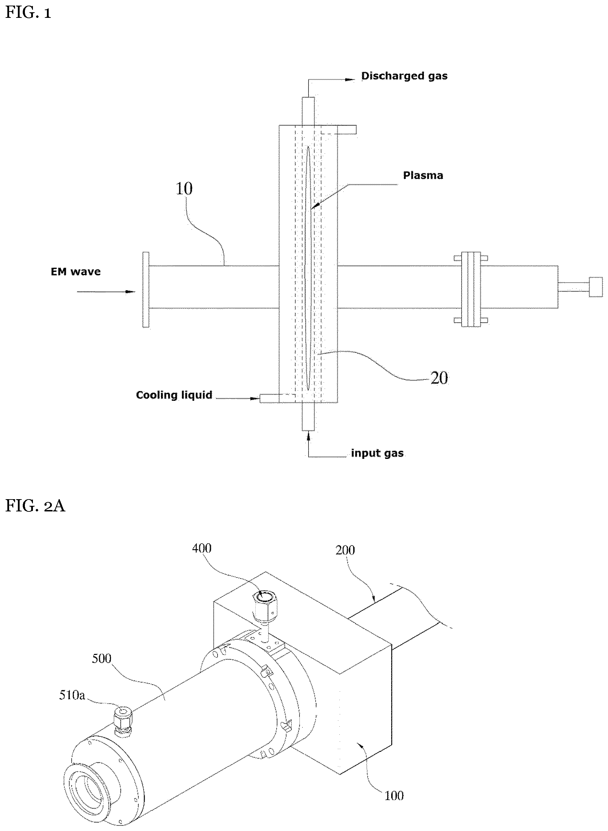

In a surfaguide approach, which is a typical example of the surface wave plasma approach, a plasma generator includes a dielectric discharge tube 20 and a waveguide 10 for transmitting an electromagnetic wave to the discharge tube 20 as shown in FIG. 1. The dielectric discharge tube 20 extends perpendicularly to the waveguide 10 and communicates with the waveguide 10. The discharge tube 20 is made of a dielectric through which electromagnetic waves can pass. A discharge gas is injected into the discharge tube 20. In this configuration, the electromagnetic wave transmitted through the waveguide 10 is introduced into the discharge tube 20. Subsequently, the electromagnetic wave introduced into the discharge tube 20 reacts with the discharge gas injected into the discharge tube 20, thereby generating plasma inside the discharge tube 20.

In the surface wave plasma generator shown in FIG. 1, in order to generate the surface wave plasma, electromagnetic waves must be transmitted to the discharged gas through the dielectric. As a result, since the generated plasma has a very high thermal energy, it is necessary to efficiently cool the dielectric discharge tube to prevent discharge tube rupture and damage. To do this, the surface wave plasma discharge tube has a double tube structure for injecting cooling fluid. As a result, the cooling fluid flows between an inner tube and an outer tube of the dual tube structure.

Cooling of the dielectric discharge tube is usually sufficient by air-cooling when the plasma density is low. However, when the plasma density is high, direct cooling by the cooling fluid is efficient. However, in terms of transmission of electromagnetic waves, the presence of the cooling fluid between the inner tube and the outer tube lowers the efficiency of electromagnetic wave transmission.

The cooling fluid may be mainly classified into dielectric oil and deionized water. In the case of dielectric oil, the electromagnetic wave transmission efficiency is excellent due to the low loss tangent of the dielectric. However, due to the low cooling efficiency of oil, cooling cycles with high pressure and large flow rate are required. This requires an additional oil chiller that requires high power consumption. Above all, the biggest disadvantage is that these oil cooling fluids can be a major source of contamination in semiconductor/display processes where cleanliness is paramount. For this reason, it is not preferable to use oil as the cooling fluid. To the contrary, de-ionized water is used as the cooling fluid. Such de-ionized water has good cooling efficiency, but does not have dielectric properties of high purity as dielectric oil. Thus, the use of de-ionized water leads to higher energy losses than using the dielectric oil. Therefore, in designing the discharge tube, it is necessary to design the discharge tube that minimizes the electromagnetic wave loss.

A major disadvantage of the cooling system using such a refrigerant is that, when cracks occur in the dielectric discharge tube, the cooling fluid can leak directly into the chamber. There is a need to fundamentally solve this problem.

Such a discharge tube structure of the surface wave plasma apparatus leads to a limitation in a power of the applied electromagnetic wave, hence, limitation of the processed gas flow rate, and a reduction of the amount of radicals that can be generated. As a result, the surface wave plasma may be limited in terms of its performance, operating range and applications.

Meanwhile, the conventional surface wave plasma apparatus uses the waveguide. That is, a transmission line for transmitting electromagnetic waves from the magnetron to the plasma discharge tube is constructed using a waveguide in a form of a fixed tube. As a result, when the magnetron and the plasma discharge tube are arranged such that the path through which the electromagnetic wave is transmitted from the magnetron to the discharge tube is not parallel to the direction of the electromagnetic wave transmission in the waveguide, the transmission line cannot be flexibly moved or adjusted. Accordingly, it is difficult to construct the transmission line for transmitting the electromagnetic wave because the fixed tube type waveguide structure to be constructed should be bent to change the transmission direction of the electromagnetic wave.

Document US4810933 discloses a surface wave launcher arranges to produce plasma columns and means for producing plasma of different shapes, wherein a propagating surface wave is generated in a dielectric vessel containing gas to be energized. An impedance matching network comprises a coupler and a tuner, which is formed by a section of a transmission line or is of the lumped circuitry type.

WO2014/009412A1 discloses a surface wave plasma generator comprising a coaxial assembly and a dielectric tube inserted into said assembly.

### SUMMARY

This Summary is provided to introduce a selection of concepts in a simplified form that are further described below in the Detailed Description. This Summary is not intended to identify all key features or essential features of the claimed subject matter, nor is it intended to be used alone as an aid in determining the scope of the claimed subject matter.

The present disclosure is to provide a coaxial-cable coupled and water-cooled SWP (surface wave plasma) generator wherein transmission of electromagnetic waves is implemented using a coaxial cable so that there is no restriction on installation space and transmission distance of electromagnetic waves, or an electromagnetic wave transmission line is constructed so that flexible movement thereof can be performed as needed.

Further, the present disclosure provides a coaxial-cable coupled and water-cooled SWP (surface wave plasma) generator wherein a dimension of the surface wave plasma SWP generator is reduced, the cooling fluid does not flow into the dielectric tube in spite of cracks in the dielectric tube, the electromagnetic wave input into the dielectric tube is not lost by the cooling fluid, and it is possible to efficiently transmit the electromagnetic wave into the dielectric tube without loss of the electromagnetic wave.

Accordingly, in one aspect of the present invention, there is provided a coaxial cable coupled and water cooled surface plasma generator according to claim 1.

Preferred embodiments of the present invention are defined in the dependent claims.

In one implementation, the discharge gas injection unit fluid-communicates with the dielectric tube at a position adjacent to the first end portion of the dielectric tube.

In one implementation, the generator further includes a cooling jacket including a hollow tube body having a second inner space defined by a surrounding wall thereof, wherein the dielectric tube is at least partially inserted into the second inner space such that an inner face of the wall contacts an outer face of the dielectric tube, wherein the cooling jacket include a coolant channel defined between the inner face and an outer face of the wall, and the coolant channel extends in a length direction of the hollow tube body and along a circumference of the hollow tube body, wherein a coolant fluid flows along the coolant channel.

In one implementation, the hollow connector has a first open side end facing the dielectric tube, wherein the first end portion of the dielectric tube passes through the first open side end of the hollow connector and into the first inner space of the hollow connector, wherein the first end portion is electromagnetically coupled to the hollow connector.

In one implementation, the generator further includes an electromagnetic wave emission antenna, wherein the electromagnetic wave emission antenna has first and second opposite ends, wherein the first end of the electromagnetic wave emission antenna is coupled to the core of the coaxial-cable and the second end of the electromagnetic wave emission antenna is inserted into or passes through the first inner space of the hollow connector, wherein the second end of the electromagnetic wave emission antenna faces the first end portion of the dielectric tube.

In one implementation, the second end of the electromagnetic wave emission antenna is spaced from or contacts the first end portion of the dielectric tube.

In one implementation, a length between the first and second ends of the electromagnetic wave emission antenna is at least one-half a width of the hollow connector, wherein the width direction is parallel to a direction of extension of the electromagnetic wave emission antenna; and wherein the second end of the electromagnetic wave emission antenna is spaced from or contacts the first end portion of the dielectric tube, and wherein the first end portion of the dielectric tube is inserted into the second inner space of the cooling jacket; or wherein the first end portion of the dielectric tube passes through a first open side end of the hollow connector and into the first inner space of the hollow connector.

In one implementation, a thickness or diameter of the electromagnetic wave emission antenna is smaller than an inner diameter of the dielectric tube.

In one implementation, the generator further includes an electromagnetic wave transmission member disposed in the first inner space, wherein the first end portion of the dielectric tube passes through a first open side end of the hollow connector and into the first inner space of the hollow connector, wherein the second end of the electromagnetic wave emission antenna is inserted into the first inner space of the hollow connector, wherein the electromagnetic wave transmission member surrounds the first end portion of the dielectric tube, and surrounds the second end of the electromagnetic wave emission antenna.

In one implementation, the generator further includes an electromagnetic wave transmission member disposed in the first inner space; and a cooling jacket including a hollow tube body having a second inner space defined by a surrounding wall thereof, wherein the dielectric tube is received in the second inner space; wherein the second end of the electromagnetic wave emission antenna is inserted into the first inner space of the hollow connector, wherein the first end portion of the dielectric tube is received in the second inner space, wherein the electromagnetic wave transmission member contacts the first end portion of the dielectric tube, and surrounds the second end of the electromagnetic wave emission antenna.

In one implementation, the generator further includes an electromagnetic wave transmission member disposed in the first inner space; and a cooling jacket including a hollow tube body having a second inner space defined by a surrounding wall thereof, wherein the dielectric tube is received in the second inner space; wherein the second end of the electromagnetic wave emission antenna passes through the first inner space of the hollow connector and is inserted into the second inner space; wherein the first end portion of the dielectric tube is received in the second inner space, wherein the electromagnetic wave transmission member is partially formed in the second inner space, wherein the electromagnetic wave transmission member contacts the first end portion of the dielectric tube, and surrounds the second end of the electromagnetic wave emission antenna.

In accordance with the present disclosure, the transmission of electromagnetic waves is implemented using the coaxial cable so that there is no restriction on installation space and transmission distance of electromagnetic waves, or an electromagnetic wave transmission line is constructed so that flexible movement thereof can be performed as needed. Further, in accordance with the present disclosure, the dimension of the surface wave plasma SWP generator is reduced compared to the conventional the surface wave plasma SWP generator, the cooling fluid does not flow into the dielectric tube in spite of cracks in the dielectric tube, the electromagnetic wave input into the dielectric tube is not lost by the cooling fluid, and it is possible to efficiently transmit the electromagnetic wave into the dielectric tube without loss of the electromagnetic wave.

### BRIEF DESCRIPTION OF THE DRAWINGS

The accompanying drawings, which are incorporated in and form a part of this specification and in which like numerals depict like elements, illustrate embodiments of the present disclosure and, together with the description, serve to explain the principles of the disclosure.
FIG. 1 is a view showing a configuration of a conventional surface wave plasma generator.
FIGS. 2A and 2B are perspective views showing appearance of a coaxial-cable coupled and water-cooled SWP generator according to an embodiment of the present invention.
FIG. 3 is a cross-sectional view of the coaxial-cable coupled and water-cooled surface wave plasma SWP generator shown in FIG. 2; FIG. 3 is a cross-sectional view showing an example of an electromagnetic wave coupling state of a dielectric tube through an electromagnetic wave emission antenna for a coaxial-cable coupled and water-cooled SWP generator according to an embodiment of the present invention.
FIG. 4 is a cross-sectional view showing another example of an electromagnetic wave coupling state of a dielectric tube through an electromagnetic wave emission antenna for a coaxial-cable coupled and water-cooled SWP generator according to an embodiment of the present invention.
FIG. 5 is a cross-sectional view illustrating still another example of an electromagnetic wave coupling state of a dielectric tube through an electromagnetic wave emission antenna for a coaxial-cable coupled and water-cooled SWP generator according to an embodiment of the present invention.

### DETAILED DESCRIPTIONS

For simplicity and clarity of illustration, elements in the figures are not necessarily drawn to scale. The same reference numbers in different figures denote the same or similar elements, and as such perform similar functionality. Also, descriptions and details of well-known steps and elements are omitted for simplicity of the description. Furthermore, in the following detailed description of the present disclosure, numerous specific details are set forth in order to provide a thorough understanding of the present disclosure. However, it will be understood that the present disclosure may be practiced without these specific details. In other instances, well-known methods, procedures, components, and circuits have not been described in detail so as not to unnecessarily obscure aspects of the present disclosure.

Examples of various embodiments are illustrated and described further below. It will be understood that the description herein is not intended to limit the scope of the invention to the specific embodiments described. The scope of the present invention is defined by the appended claims.

It will be understood that, although the terms "first", "second", "third", and so on may be used herein to describe various elements, components, regions, layers and/or sections, these elements, components, regions, layers and/or sections should not be limited by these terms. These terms are used to distinguish one element, component, region, layer or section from another element, component, region, layer or section. Thus, a first element, component, region, layer or section described below could be termed a second element, component, region, layer or section, without departing from the spirit and scope of the present disclosure.

It will be understood that when an element or layer is referred to as being "connected to", or "coupled to" another element or layer, it can be directly on, connected to, or coupled to the other element or layer, or one or more intervening elements or layers may be present. In addition, it will also be understood that when an element or layer is referred to as being "between" two elements or layers, it can be the only element or layer between the two elements or layers, or one or more intervening elements or layers may also be present.

Spatially relative terms, such as "beneath," "below," "lower," "under," "above," "upper," and the like, may be used herein for ease of explanation to describe one element or feature's relationship to another element s or feature s as illustrated in the figures. It will be understood that the spatially relative terms are intended to encompass different orientations of the device in use or in operation, in addition to the orientation depicted in the figures. For example, if the device in the figures is turned over, elements described as "below" or "beneath" or "under" other elements or features would then be oriented "above" the other elements or features. Thus, the example terms "below" and "under" can encompass both an orientation of above and below. The device may be otherwise oriented for example, rotated 90 degrees or at other orientations, and the spatially relative descriptors used herein should be interpreted accordingly.

The terminology used herein is for the purpose of describing particular embodiments only and is not intended to be limiting of the present disclosure. As used herein, the singular forms "a" and "an" are intended to include the plural forms as well, unless the context clearly indicates otherwise. It will be further understood that the terms "comprises", "comprising", "includes", and "including" when used in this specification, specify the presence of the stated features, integers, operations, elements, and/or components, but do not preclude the presence or addition of one or more other features, integers, operations, elements, components, and/or portions thereof. As used herein, the term "and/or" includes any and all combinations of one or more of the associated listed items. Expression such as "at least one of' when preceding a list of elements may modify the entire list of elements and may not modify the individual elements of the list.

Unless otherwise defined, all terms including technical and scientific terms used herein have the same meaning as commonly understood by one of ordinary skill in the art to which this inventive concept belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

In the following description, numerous specific details are set forth in order to provide a thorough understanding of the present disclosure. The present disclosure may be practiced without some or all of these specific details. In other instances, well-known process structures and/or processes have not been described in detail in order not to unnecessarily obscure the present disclosure.

As used herein, the term "substantially," "about," and similar terms are used as terms of approximation and not as terms of degree, and are intended to account for the inherent deviations in measured or calculated values that would be recognized by those of ordinary skill in the art. Further, the use of "may" when describing embodiments of the present disclosure refers to "one or more embodiments of the present disclosure."

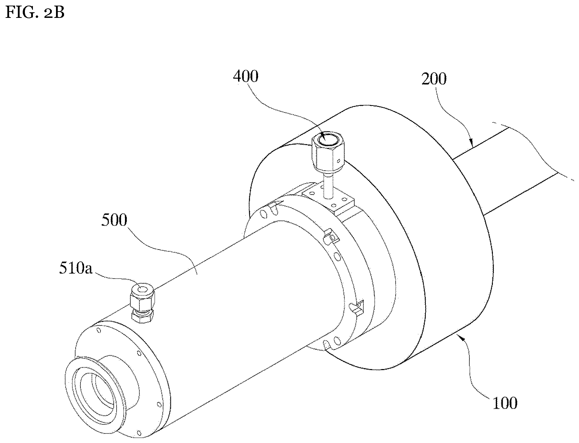

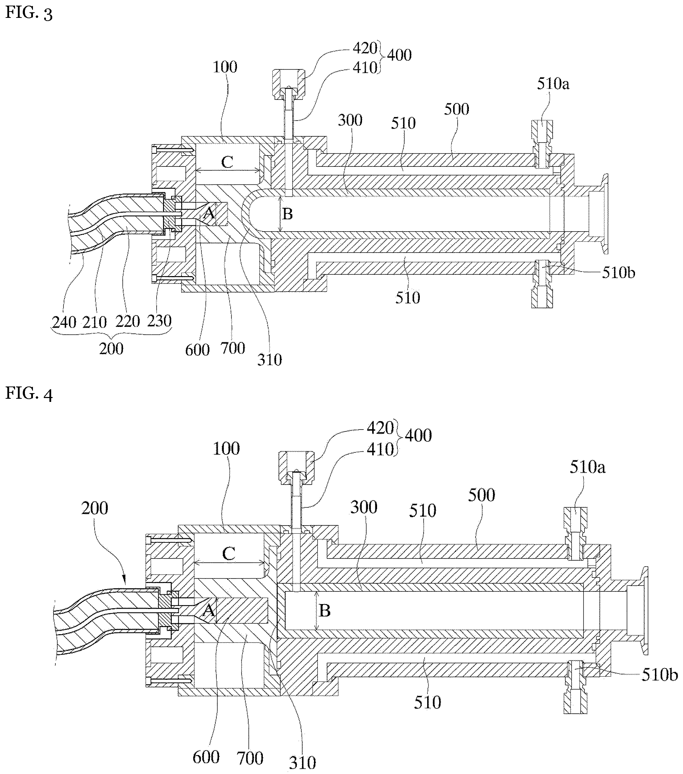

FIGS. 2A and 2B are perspective views showing appearance of a coaxial-cable coupled and water-cooled SWP generator according to an embodiment of the present invention. FIG. 3 is a cross-sectional view of the coaxial-cable coupled and water-cooled surface wave plasma SWP generator shown in FIG. 2. More specifically,

FIG. 3 is a cross-sectional view showing an example of an electromagnetic wave coupling state of a dielectric tube through an electromagnetic wave emission antenna for a coaxial-cable coupled and water-cooled SWP generator according to an embodiment of the present invention.

Referring to FIG. 2A to FIG. 3, the coaxial-cable coupled and water-cooled SWP (surface wave plasma) generator according to an exemplary embodiment of the present invention includes a hollow connector 100, a coaxial cable 200, a dielectric tube 300, and a discharge gas injection unit 400.

The hollow connector 100 has an internal space defined therein for confining therein electromagnetic waves incident thereto from the outside. In one embodiment, the hollow connector 100 may be in the form of a rectangular parallelepiped or a cuboid, as shown in FIG. 2A, or may be in the shape of a cylinder, as shown in FIG. 2B.

The coaxial cable 200 transmits electromagnetic waves into the hollow connector 100. The coaxial cable 200 includes the core 210 for transmitting electromagnetic waves generated from an electromagnetic wave oscillation unit (not shown). The distal end of the core is positioned inside the hollow connector 100 so that the core 210 transmits the electromagnetic wave generated from the electromagnetic wave oscillation unit to the inside of the hollow connector 100.

In one embodiment, the coaxial cable 200 comprises a core 210, an insulating layer 220 made of a flexible material surrounding the core 210, a flexible outer conductive coating 240 surrounding the insulating layer, and a distal end connector 230 disposed on a distal end of the outer conductive coating 240 and the insulating layer 220. The core 210 may extend beyond the distal end connector 230 into the hollow connector 100. In this case, the distal end connector 230 may be fixed to one side of the hollow connector 100, and the core 210 may be inserted into the hollow connector 100.

The dielectric tube 300 has an inner space therein defined therein, in which electromagnetic waves and discharge gases react with each other to produce high-temperature plasma. The dielectric tube 300 is electromagnetic wave-coupled to the hollow connector 100 to receive electromagnetic waves therein.

In one embodiment, the dielectric tube 300 has an inner end facing the hollow connector 100. The hollow connector 100 has an inner end facing the dielectric tube 300. The hollow connector 100 has an outer end that partially accommodates the coaxial cable 200. The inner end of the hollow connector 100 is open. Therefore, the inner end of the dielectric tube 300 passes through the inner end of the hollow connector 100 and then into the inner space of the hollow connector 100.

In this case, there is achieved an electromagnetic wave coupling state in which an electromagnetic wave inputted into the hollow connector 100 may be inputted through the inserted portion of the dielectric tube 300 into the hollow connector 100 into the inner space of the dielectric tube 300.

The shape of the dielectric tube 300 is not particularly limited. For example, the dielectric tube 300 may be cylindrical. Hereinafter, for convenience of explanation, the inner end of the dielectric tube 300 connected to the hollow connector 100 and receiving the electromagnetic waves will be referred to as "electromagnetic wave receiving end-portion 310".

The discharge gas injection unit 400 is in fluid-communication with the dielectric tube 300 to inject a discharge gas into the dielectric tube 300. In one embodiment, the discharge gas injection unit 400 may include a gas injection tube 410 connected to the dielectric tube 300 and a gas injector 420 provided at an upper end of the gas injection tube 410. The discharge gas injection tube 410 is disposed adjacent to the electromagnetic wave receiving end-portion 310 of the dielectric tube 300 connected to the hollow connector 100, so that the discharge gas readily reacts with the electromagnetic waves to generate plasma.

The coaxial-cable coupled and water-cooled SWP (surface wave plasma) generator according to an embodiment of the present invention may further include a cooling jacket 500.

The cooling jacket 500 is configured to cool the dielectric tube 300. The cooling jacket 500 is in the form of a hollow tube with an inner diameter that can wrap around the dielectric tube 300. The inner surface of the hollow portion thereof contacts the outer surface of the dielectric tube 300 and surrounds the dielectric tube 300. The length of the cooling jacket 500 is not particularly limited. The length of the jacket may have a length that can cover the entire length or a portion of the portion of the dielectric tube 300 extending outside the hollow connector 100. In one embodiment, as shown in FIG. 3, when the electromagnetic wave receiving end-portion 310 of the dielectric tube 200 is inserted through the open inner end of the hollow connector 100 and into the hollow connector 100, the cooling jacket 500 may be configured to wrap the entire length of the portion of the dielectric tube 300 extending outside the hollow connector 100.

This cooling jacket 500 includes a coolant channel 510 for circulating the coolant fluid to cool the dielectric tube 300 as previously mentioned. The coolant channel 510 is configured to allow the coolant fluid to flow along the longitudinal and circumferential directions of the cooling jacket 500. For example, the coolant channel 510 has a circular ring shape when viewed from a cross-section perpendicular to the axial direction of the cooling jacket 500. The circular ring shape extends along the longitudinal direction of the cooling jacket 500. Thus, the coolant channel 510 has a cylindrical shape. The coolant channel 510 is located between the inner and outer surfaces of the cooling jacket 500 and does not contact the outer surface of the dielectric tube 300. Accordingly, the coolant fluid traveling along the coolant channel 510 may flow only within the cooling jacket 500 without contacting the dielectric tube 300. The coolant channel 510 may include an inlet 510a and an outlet 510b to allow the coolant fluid to circulate into and out of the cooling jacket 500.

The cooling jacket 500 may also be made of a highly conductive metal material to cool the dielectric tube 300 while surrounding the dielectric tube 300. For example, the cooling jacket 500 may be made of aluminum.

In the meantime, the coaxial-cable coupled and water-cooled SWP generator according to an embodiment of the present invention includes an electromagnetic wave emission antenna 600 and an electromagnetic wave transmission member 700 to efficiently transmit the electromagnetic waves to the dielectric tube 300.

The electromagnetic wave emission antenna 600 has an outer end connected to the core 210 of the coaxial cable 200 and the inner end inserted into the hollow connector 100 so as to face away the electromagnetic wave receiving end-portion 310. That is, the electromagnetic wave emission antenna 600 extends, inside the hollow connector 100, from the outer side end of the hollow connector 100 toward the electromagnetic wave receiving end-portion 310 of the dielectric tube 300 disposed at the inner side end of the connector 100. The electromagnetic wave emission antenna 600 may have a columnar shape, for example, a cylindrical shape. The electromagnetic wave emission antenna 600 emits the electromagnetic waves received from the core 210 toward the electromagnetic wave receiving end-portion 310 of the dielectric tube 300, thereby inputting electromagnetic waves into the dielectric tube 300.

The extension length of the electromagnetic wave emission antenna 600 may be configured to allow the antenna 600 to be spaced apart or in contact with the electromagnetic wave receiving end-portion 310 of the dielectric tube 200. Preferably, the extension length of the electromagnetic wave emission antenna 600 may be at least one-half a width C (between the inner and outer side faces) of the hollow connector 100 parallel to the direction of extension of the electromagnetic wave emission antenna 600.

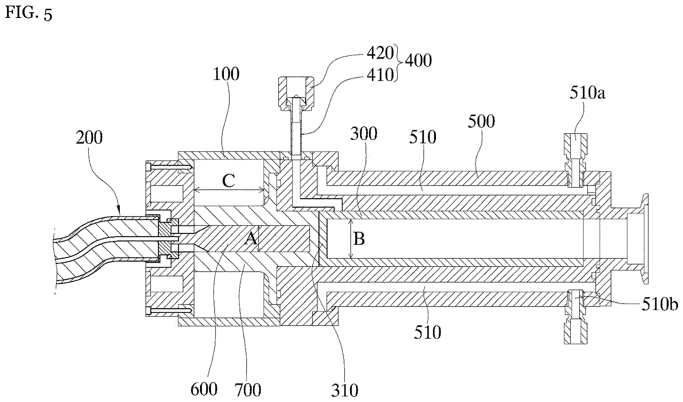

FIG. 4 is a cross-sectional view showing another example of an electromagnetic wave coupling state of a dielectric tube through an electromagnetic wave emission antenna for a coaxial-cable coupled and water-cooled SWP generator according to an embodiment of the present invention. FIG. 5 is a cross-sectional view illustrating still another example of an electromagnetic wave coupling state of a dielectric tube through an electromagnetic wave emission antenna for a coaxial-cable coupled and water-cooled SWP generator according to an embodiment of the present invention.

FIG. 3 is a cross-sectional view showing one example of an electromagnetic wave coupling state of a dielectric tube through an electromagnetic wave emission antenna for a coaxial-cable coupled and water-cooled SWP generator according to an embodiment of the present invention. In FIG. 3, the electromagnetic wave emission antenna 600 may be referred to as a first the electromagnetic wave emission antenna 600. In one embodiment, as shown in FIG. 3, the extension length of the electromagnetic wave emission antenna 600 may substantially one-half a width C (between the inner and outer side faces) of the hollow connector 100 parallel to the direction of extension of the electromagnetic wave emission antenna 600. In this connection, the portion inserted into the hollow connector 100 of the electromagnetic wave receiving end-portion 310 of the dielectric tube 300 may be spaced apart from the electromagnetic wave emission antenna 600.

In another embodiment, as shown in FIG. 4, the extension length of the electromagnetic wave emission antenna 600 may substantially the width C (between the inner and outer side faces) of the hollow connector 100 parallel to the direction of extension of the electromagnetic wave emission antenna 600. In this connection, the portion inserted into the hollow connector 100 of the electromagnetic wave receiving end-portion 310 of the dielectric tube 300 may be spaced apart from the electromagnetic wave emission antenna 600. In this connection, the electromagnetic wave receiving end-portion 310 of the dielectric tube 300 is located inside the cooling jacket 500 and is positioned close to the electromagnetic wave emission antenna 600. In this embodiment, the electromagnetic wave emission antenna 600 may be referred to as a second electromagnetic wave emission antenna 600.

In still another embodiment, as shown in FIG. 5, the extension length of the electromagnetic wave emission antenna 600 may exceed the width C (between the inner and outer side faces) of the hollow connector 100 parallel to the direction of extension of the electromagnetic wave emission antenna 600. That is, the electromagnetic wave emission antenna 600 may extend through the open inner side end of the connector 100 and then extend into in the inner space of the cooling jacket 500. In this connection, the portion of the electromagnetic wave emission antenna 600 inserted into the inner space of the cooling jacket 500 may be spaced apart from the electromagnetic wave receiving end-portion 310 of the dielectric tube 300. In this connection, the electromagnetic wave receiving end-portion 310 of the dielectric tube 300 is located in the inner space of the cooling jacket 500 and is positioned close to the electromagnetic wave emission antenna 600. In this embodiment, the electromagnetic wave emission antenna 600 may be referred to as a third electromagnetic wave emission antenna 600.

In this connection, a thickness or diameter A of the first, second and/or third electromagnetic wave emission antenna 600 is less than the inner diameter B of the dielectric tube 300. Since the thickness or diameter A of the first, second and/or third electromagnetic wave emission antenna 600 is less than the inner diameter B of the dielectric tube 300, the electromagnetic waves emitted from the first, second and/or third electromagnetic wave emission antenna 600 may be uniformly radiated over the entire radial region of the dielectric tube 300.

The electromagnetic wave transmission member 700 connects the electromagnetic wave emission antenna 600 and the dielectric tube 300. In one embodiment, as shown in FIG. 3, the electromagnetic wave transmission member 700 may be disposed within the hollow connector 100 so as to surround the first electromagnetic wave emission antenna 600 and the electromagnetic wave receiving end portion 310 of the dielectric tube 300 inserted into the hollow connector 100.

In another embodiment, as shown in FIG. 4, the electromagnetic wave transmission member 700 may be disposed within the hollow connector 100 so as to surround the entire second electromagnetic wave emission antenna 600, and contact the electromagnetic wave receiving end portion 310 of the dielectric tube 300.

In still another embodiment, as shown in FIG. 5, the electromagnetic wave transmission member 700 may be disposed within the hollow connector 100 so as to surround the entire second electromagnetic wave emission antenna 600, and to be inserted into the inner space of the cooling jacket 500 to contact the electromagnetic wave receiving end portion 310 of the dielectric tube 300.

The electromagnetic wave transmission member 700 is made of a dielectric. Since the electromagnetic wave transmission member 700 is made of a dielectric, the electromagnetic waves transmitted inside the hollow connector 100 may be transmitted from the electromagnetic wave emission antenna 600 via the electromagnetic wave transmission member 700 to the dielectric tube 300.

Hereinafter, a process of generating plasma using the coaxial-cable coupled and water-cooled surface wave plasma (SWP) generator according to an embodiment of the present invention will be described.

First, electromagnetic waves generated from an electromagnetic wave oscillating unit (not shown) are transmitted via the core 210 of the coaxial cable 200 and input into the hollow connector 100. At the same time, discharge gas is injected from the discharge gas injection unit 400 into the dielectric tube 300.

The electromagnetic wave transmitted to the inside of the hollow connector 100 is radiated toward the electromagnetic wave receiving end-portion 310 of the dielectric tube 300 via the electromagnetic wave emission antenna 600 connected to the core 210 of the coaxial-cable 200. In this connection, the electromagnetic wave emission antenna 600 and/or the electromagnetic wave receiving end-portion 310 of the dielectric tube 300 are surrounded by the electromagnetic wave transmission member 700. Thus, the electromagnetic wave transmitted to the hollow connector 100 may be efficiently transmitted to the electromagnetic wave emission antenna 600 and, thus, the electromagnetic wave radiated from the electromagnetic wave emission antenna 600 may be effectively and efficiently transmitted to the electromagnetic wave receiving end portion 310 of the dielectric tube 300 via the electromagnetic wave transmission member 700. In this way, the electromagnetic waves are input into the dielectric tube 300.

Then, the electromagnetic waves input into the dielectric tube 300 react with the discharge gas injected from the discharge gas injection unit 400 into the dielectric tube 300 to generate a high-temperature plasma.

The coolant fluid is injected into the inlet 510a of the coolant channel 510 to cool the dielectric tube 300 with the elevated temperature through the resulting hot plasma. The coolant fluid injected into the coolant channel 510 travels along the coolant channel 510 and along the length and circumferential directions of the cooling jacket 500. Thus, the cooling jacket 500 is cooled, and, then, the lowered heat of the cooling jacket 500 is conducted to the dielectric tube 300 to cool the dielectric tube 300. The coolant fluid passing through the coolant channel 510 is discharged through the outlet 510b of the coolant channel 510 to the outside of the cooling jacket 500. The fluid may be collected from a coolant fluid supply illustrated previously, and then fed back to the inlet 510a of the coolant channel 510. Thereby, cooling fluid circulation is achieved.

In the coaxial-cable coupled and water-cooled SWP (surface wave plasma) generator according to the present invention, the dielectric tube 300 and the electromagnetic wave oscillation unit (not shown) far away from the dielectric tube 300 may be coupled to each other via the coaxial-cable 200, which has a flexible nature. Thus, when the dielectric tube 300 and the electromagnetic wave oscillator are located at a distance from each other, and/or when the space for installation of the water-cooled surface wave plasma generator is narrow, and/or when the plasma generator needs to move, the flexible coaxial-cable 200 may allow easy flexible connection between the dielectric tube 300 and the electromagnetic wave oscillator, and/or allow reliable transmission of the electromagnetic waves to the dielectric tube 300, and allow easy movement of the plasma generator, and/or facilitate the installation of the plasma generator.

In addition, even when the electromagnetic wave oscillation unit and the dielectric tube 300 are located in a non-parallel to each other and in an angled manner with each other, the transmission line between the electromagnetic wave oscillation unit and the dielectric tube 300 can be easily constructed using the flexible coaxial cable 200.

Further, the waveguide may be omitted. Further, the electromagnetic wave is transmitted via the electromagnetic wave emission antenna 600 located inside the hollow connector 100 toward the end of the dielectric tube 300. Thus, the present surface wave plasma generator may have a reduced size in comparison with the conventional surface wave plasma generator having a configuration in which the wave guide passes through perpendicularly the discharge tube.

The dielectric tube 300 is surrounded by the cooling jacket 500, and the inner surface of the discharge inner space defined in the cooling jacket 500 contacts the outer surface of the dielectric tube 300. The coolant fluid circulates through the coolant channel 510 formed inside a body of the cooling jacket 500. This allows indirect cooling of the dielectric tube 300 via the thermal conduction of the cooling jacket 500. This prevents the coolant fluid from leaking into the dielectric tube 300, even when the dielectric tube 300 is in continuous contact with a hot plasma for a long time and cracking occurs in the tube 300.

Furthermore, the electromagnetic waves may be transmitted toward the end portion 310 of the dielectric tube 300 through the electromagnetic wave emission antenna 600 located inside the hollow connector 100. As a result, the coolant fluid does not flow into the hollow connector 100, so that the power of electromagnetic waves input to the dielectric tube 300 is prevented from being lost by the coolant fluid.

Moreover, the extension length of the electromagnetic wave emission antenna 600 may be configured to allow the antenna 600 to be spaced apart or in contact with the electromagnetic wave receiving end-portion 310 of the dielectric tube 200. Preferably, the extension length of the electromagnetic wave emission antenna 600 may be at least one-half the width C (between the inner and outer side faces) of the hollow connector 100 parallel to the direction of extension of the electromagnetic wave emission antenna 600. Further, the thickness or diameter A of the first, second and/or third electromagnetic wave emission antenna 600 is less than the inner diameter B of the dielectric tube 300. Thus, the electromagnetic waves emitted from the first, second and/or third electromagnetic wave emission antenna 600 may be uniformly radiated over the entire radial region of the dielectric tube 300. In addition, there is an advantage that the electromagnetic wave emission antenna 600 can efficiently transmit the power of the electromagnetic wave to the dielectric tube 300 without loss thereof.

Finally, since the electromagnetic wave transmission member 700 made of a dielectric surrounds the electromagnetic wave emission antenna 600 in the hollow connector 100, there is an advantage that the antenna 600 may efficiently transmit the electromagnetic waves transmitted in the hollow connector 100 via the electromagnetic wave transmission member 700 to the dielectric tube 300 without loss.

The above description is not to be taken in a limiting sense, but is made merely for the purpose of describing the general principles of exemplary embodiments, and many additional embodiments of this disclosure are possible. The scope of the present invention is defined by the appended claims.

## Claims

1. A coaxial-cable coupled and water-cooled SWP (surface wave plasma) generator, wherein the generator comprises:
a hollow connector (100) having a first inner space defined therein;
a coaxial-cable (200) connected to the hollow connector (100), wherein the coaxial-cable (200) has a core (210) configured to transmit an electromagnetic wave from an electromagnetic wave oscillating unit to the hollow connector (100), wherein the core (210) extends into the first inner space of the hollow connector (100), and
a dielectric tube (300), wherein the dielectric tube has a first end portion (310) electromagnetically coupled to the hollow connector (100) so that the electromagnetic wave transmitted into the hollow connector (100) is electromagnetically inputted into the dielectric tube (300); and
a discharge gas injection unit (400) fluid-communicating with the dielectric tube (300) to inject a discharge gas into the dielectric tube (300).

2. The generator of claim 1, wherein the discharge gas injection unit (400) fluid-communicates with the dielectric tube (300) at a position adjacent to the first end portion of the dielectric tube (300).

3. The generator of claim 1, further comprising a cooling jacket (500) including a hollow tube body having a second inner space defined by a surrounding wall thereof, wherein the dielectric tube (300) is at least partially inserted into the second inner space such that an inner face of the wall contacts an outer face of the dielectric tube (300), wherein the cooling jacket (500) includes a coolant channel (510) defined between the inner face and an outer face of the wall, and the coolant channel (510) extends in a length direction of the hollow tube body and along a circumference of the hollow tube body, wherein a coolant fluid flows along the coolant channel (510).

4. The generator of claim 1, wherein the hollow connector (100) has a first open side end facing the dielectric tube (300), wherein the first end portion of the dielectric tube (300) passes through the first open side end of the hollow connector (100) and into the first inner space of the hollow connector (100), wherein the first end portion is electromagnetically coupled to the hollow connector (100).

5. The generator of claim 4, further comprising an electromagnetic wave emission antenna (600), wherein the electromagnetic wave emission antenna (600) has first and second opposite ends, wherein the first end of the electromagnetic wave emission antenna (600) is coupled to the core of the coaxial-cable (200) and the second end of the electromagnetic wave emission antenna (600) is inserted into or passes through the first inner space of the hollow connector (100), wherein the second end of the electromagnetic wave emission antenna (600) faces the first end portion of the dielectric tube (300).

6. The generator of claim 5, wherein the second end of the electromagnetic wave emission antenna (600) is spaced from or contacts the first end portion of the dielectric tube (300).

7. The generator of claim 5, wherein a length between the first and second ends of the electromagnetic wave emission antenna (600) is at least one-half a width of the hollow connector (100), wherein the width direction is parallel to a direction of extension of the electromagnetic wave emission antenna (600); and
wherein the second end of the electromagnetic wave emission antenna (600) is spaced from or contacts the first end portion of the dielectric tube (300); and
wherein the first end portion of the dielectric tube (300) is inserted into the second inner space of the cooling jacket (500); or
wherein the first end portion of the dielectric tube (300) passes through a first open side end of the hollow connector (100) and into the first inner space of the hollow connector (100).

8. The generator of claim 5, wherein a thickness or diameter of the electromagnetic wave emission antenna (600) is smaller than an inner diameter of the dielectric tube (300).

9. The generator of claim 5, further comprising an electromagnetic wave transmission member (700) disposed in the first inner space,
wherein the first end portion of the dielectric tube (300) passes through a first open side end of the hollow connector (100) and into the first inner space of the hollow connector (100),
wherein the second end of the electromagnetic wave emission antenna (600) is inserted into the first inner space of the hollow connector (100), wherein the electromagnetic wave transmission member (700) surrounds the first end portion of the dielectric tube (300), and surrounds the second end of the electromagnetic wave emission antenna (600).

10. The generator of claim 5, further comprising:
an electromagnetic wave transmission member (700) disposed in the first inner space; and
a cooling jacket (500) including a hollow tube body having a second inner space defined by a surrounding wall thereof, wherein the dielectric tube (300) is received in the second inner space;
wherein the second end of the electromagnetic wave emission antenna (600) is inserted into the first inner space of the hollow connector (100),
wherein the first end portion of the dielectric tube (300) is received in the second inner space,
wherein the electromagnetic wave transmission member (700) contacts the first end portion of the dielectric tube (300), and surrounds the second end of the electromagnetic wave emission antenna (600).

11. The generator of claim 5, further comprising:
an electromagnetic wave transmission member (700) disposed in the first inner space; and
a cooling jacket (500) including a hollow tube body having a second inner space defined by a surrounding wall thereof, wherein the dielectric tube (300) is received in the second inner space;
wherein the second end of the electromagnetic wave emission antenna (600) passes through the first inner space of the hollow connector (100) and is inserted into the second inner space;
wherein the first end portion of the dielectric tube (300) is received in the second inner space,
wherein the electromagnetic wave transmission member (700) is partially formed in the second inner space, wherein the electromagnetic wave transmission member (700) contacts the first end portion of the dielectric tube (300), and surrounds the second end of the electromagnetic wave emission antenna (600).

## Patentansprüche

1. Koaxialkabel-gekoppelter und wassergekühlter SWP-(Oberflächenwellenplasma)-Generator, wobei der Generator Folgendes umfasst:
einen Hohlverbinder (100), der einen ersten darin definierten Innenraum aufweist;
ein Koaxialkabel (200), das mit dem Hohlverbinder (100) verbunden ist, wobei das Koaxialkabel (200) einen Kern (210) aufweist, der konfiguriert ist, um eine elektromagnetische Welle von einer elektromagnetischen Wellenschwingungseinheit zu dem Hohlverbinder (100) zu übertragen, wobei sich der Kern (210) in den ersten Innenraum des Hohlverbinders (100) erstreckt, und
ein dielektrisches Rohr (300),
wobei das dielektrische Rohr einen ersten Endabschnitt (310) aufweist, der elektromagnetisch mit dem Hohlverbinder (100) gekoppelt ist, sodass die elektromagnetische Welle, die in den Hohlverbinder (100) übertragen wird, elektromagnetisch in das dielektrische Rohr (300) eingegeben wird; und
eine Abgasinjektionseinheit (400), die mit dem dielektrischen Rohr (300) fluidverbunden ist, um ein Abgas in das dielektrische Rohr (300) zu injizieren.

2. Generator nach Anspruch 1, wobei die Abgasinjektionseinheit (400) mit dem dielektrischen Rohr (300) in einer Position angrenzend an den ersten Endabschnitt des dielektrischen Rohres (300) fluidverbunden ist.

3. Generator nach Anspruch 1, weiter einen Kühlmantel (500) umfassend, der einen hohlen Rohrkörper beinhaltet, der einen zweiten Innenraum aufweist, der durch eine umgebende Wand davon definiert ist, wobei das dielektrische Rohr (300) mindestens teilweise in den zweiten Innenraum eingeführt ist, sodass eine Innenseite der Wand eine Außenseite des dielektrischen Rohres (300) berührt, wobei der Kühlmantel (500) einen Kältemittelkanal (510) beinhaltet, der zwischen der Innenseite und einer Außenseite der Wand definiert ist, und sich der Kältemittelkanal (510) in einer Längsrichtung des hohlen Rohrkörpers und entlang eines Umfangs des hohlen Rohrkörpers erstreckt, wobei ein Kältemittelfluid entlang des Kältemittelkanals (510) strömt.

4. Generator nach Anspruch 1, wobei der Hohlverbinder (100) ein erstes offenseitiges Ende aufweist, das zu dem dielektrischen Rohr (300) weist, wobei der erste Endabschnitt des dielektrischen Rohres (300) durch das erste offenseitige Ende des Hohlverbinders (100) und in den ersten Innenraum des Hohlverbinders (100) hindurchverläuft, wobei der erste Endabschnitt elektromagnetisch mit dem Hohlverbinder (100) gekoppelt ist.

5. Generator nach Anspruch 4, weiter eine elektromagnetische Wellenemissionsantenne (600) umfassend, wobei die elektromagnetische Wellenemissionsantenne (600) erste und zweite entgegengesetzte Enden aufweist, wobei das erste Ende der elektromagnetischen Wellenemissionsantenne (600) mit dem Kern des Koaxialkabels (200) gekoppelt ist, und das zweite Ende der elektromagnetischen Wellenemissionsantenne (600) in den ersten Innenraum des Hohlverbinders (100) eingeführt ist oder dort hindurchverläuft, wobei das zweite Ende der elektromagnetischen Wellenemissionsantenne (600) zum ersten Endabschnitt des dielektrischen Rohres (300) weist.

6. Generator nach Anspruch 5, wobei das zweite Ende der elektromagnetischen Wellenemissionsantenne (600) vom ersten Endabschnitt des dielektrischen Rohres (300) beabstandet ist, oder diesen berührt.

7. Generator nach Anspruch 5, wobei eine Länge zwischen dem ersten und zweiten Ende der elektromagnetischen Wellenemissionsantenne (600) mindestens eine Hälfte einer Breite des Hohlverbinders (100) ist, wobei die Breitenrichtung parallel zu einer Erstreckungsrichtung der elektromagnetischen Wellenemissionsantenne (600) ist;
wobei das zweite Ende der elektromagnetischen Wellenemissionsantenne (600) vom ersten Endabschnitt des dielektrischen Rohres (300) beabstandet ist oder diesen berührt; und
wobei der erste Endabschnitt des dielektrischen Rohres (300) in den zweiten Innenraum des Kühlmantels (500) eingeführt ist; oder
wobei der erste Endabschnitt des dielektrischen Rohres (300) durch ein erstes offenseitiges Ende des Hohlverbinders (100) hindurch und in den ersten Innenraum des Hohlverbinders (100) verläuft.

8. Generator nach Anspruch 5, wobei eine Dicke oder ein Durchmesser der elektromagnetischen Wellenemissionsantenne (600) kleiner als ein Innendurchmesser des dielektrischen Rohres (300) ist.

9. Generator nach Anspruch 5, weiter ein elektromagnetisches Wellenübertragungselement (700) umfassend, das in dem ersten Innenraum angeordnet ist,
wobei der erste Endabschnitt des dielektrischen Rohres (300) durch ein erstes offenseitiges Ende des Hohlverbinders (100) hindurch und in den ersten Innenraum des Hohlverbinders (100) verläuft,
wobei das zweite Ende der elektromagnetischen Wellenemissionsantenne (600) in den ersten Innenraum des Hohlverbinders (100) eingeführt ist, wobei das elektromagnetische Wellenübertragungselement (700) den ersten Endabschnitt des dielektrischen Rohres (300) umgibt und das zweite Ende der elektromagnetischen Wellenemissionsantenne (600) umgibt.

10. Generator nach Anspruch 5, weiter umfassend:
ein elektromagnetisches Wellenübertragungselement (700), das in dem ersten Innenraum angeordnet ist; und
einen Kühlmantel (500), der einen hohlen Rohrkörper beinhaltet, der einen zweiten Innenraum aufweist, der durch eine umlaufende Wand davon definiert wird, wobei das dielektrische Rohr (300) in dem zweiten Innenraum aufgenommen ist;
wobei das zweite Ende der elektromagnetischen Wellenemissionsantenne (600) in den ersten Innenraum des Hohlverbinders (100) eingeführt ist,
wobei der erste Endabschnitt des dielektrischen Rohres (300) in dem zweiten Innenraum aufgenommen ist,
wobei das elektromagnetische Wellenübertragungselement (700) den ersten Endabschnitt des dielektrischen Rohres (300) berührt und das zweite Ende der elektromagnetischen Wellenemissionsantenne (600) umgibt.

11. Generator nach Anspruch 5, weiter umfassend:
ein elektromagnetisches Wellenübertragungselement (700), das in dem ersten Innenraum angeordnet ist; und
einen Kühlmantel (500), der einen hohlen Rohrkörper beinhaltet, der einen zweiten Innenraum aufweist, der durch eine umlaufende Wand davon definiert wird, wobei das dielektrische Rohr (300) in dem zweiten Innenraum aufgenommen ist;
wobei das zweite Ende der elektromagnetischen Wellenemissionsantenne (600) durch den Innenraum des Hohlverbinders (100) hindurchverläuft, und in den zweiten Innenraum eingeführt ist;
wobei der erste Endabschnitt des dielektrischen Rohres (300) in dem zweiten Innenraum aufgenommen ist,
wobei das elektromagnetische Wellenübertragungselement (700) teilweise in dem zweiten Innenraum gebildet ist, wobei das elektromagnetische Wellenübertragungselement (700) den ersten Endabschnitt des dielektrischen Rohres (300) berührt und das zweite Ende der elektromagnetischen Wellenemissionsantenne (600) umgibt.

## Revendications

1. Générateur de SWP (plasma à ondes de surface) couplé à un câble coaxial et refroidi à l'eau, dans lequel le générateur comprend :
un connecteur creux (100) présentant un premier espace interne défini à l'intérieur de celui-ci ;
un câble coaxial (200) connecté au connecteur creux (100), dans lequel le câble coaxial (200) présente une âme (210) configurée pour transmettre une onde électromagnétique depuis une unité oscillante à ondes électromagnétiques vers le connecteur creux (100), dans lequel l'âme (210) s'étend dans le premier espace interne du connecteur creux (100), et
un tube diélectrique (300), dans lequel le tube diélectrique présente une première portion d'extrémité (310) couplée de manière électromagnétique au connecteur creux (100) de sorte que l'onde électromagnétique transmise dans le connecteur creux (100) est entrée de manière électromagnétique dans le tube diélectrique (300) ; et
une unité d'injection de gaz de refoulement (400) communiquant de manière fluidique avec le tube diélectrique (300) pour injecter un gaz de refoulement dans le tube diélectrique (300).

2. Générateur selon la revendication 1, dans lequel l'unité d'injection de gaz de refoulement (400) communique de manière fluidique avec le tube diélectrique (300) au niveau d'une position adjacente à la première portion d'extrémité du tube diélectrique (300).

3. Générateur selon la revendication 1, comprenant en outre une chemise de refroidissement (500) incluant un corps de tube creux présentant un second espace interne défini par une paroi entourante de celui-ci, dans lequel le tube diélectrique (300) est inséré au moins partiellement dans le second espace interne de telle sorte qu'une face interne de la paroi entre en contact avec une face externe du tube diélectrique (300), dans lequel la chemise de refroidissement (500) inclut un canal à liquide de refroidissement (510) défini entre la face interne et une face externe de la paroi, et le canal à liquide de refroidissement (510) s'étend dans une direction en longueur du corps de tube creux et le long d'une circonférence du corps de tube creux, dans lequel un fluide de refroidissement s'écoule le long du canal à liquide de refroidissement (510).

4. Générateur selon la revendication 1, dans lequel le connecteur creux (100) présente une première extrémité latérale ouverte faisant face au tube diélectrique (300), dans lequel la première portion d'extrémité du tube diélectrique (300) passe à travers la première extrémité latérale ouverte du connecteur creux (100) et dans le premier espace interne du connecteur creux (100), dans lequel la première portion d'extrémité est couplée de manière électromagnétique au connecteur creux (100).

5. Générateur selon la revendication 4, comprenant en outre une antenne d'émission d'ondes électromagnétiques (600), dans lequel l'antenne d'émission d'ondes électromagnétiques présente des première et seconde extrémités opposées, dans lequel la première extrémité de l'antenne d'émission d'ondes électromagnétiques (600) est couplée à l'âme du câble coaxial (200) et la seconde extrémité de l'antenne d'émission d'ondes électromagnétiques (600) est insérée dans ou passe à travers le premier espace interne du connecteur creux (100), dans lequel la seconde extrémité de l'antenne d'émission d'ondes électromagnétiques (600) fait face à la première portion d'extrémité du tube diélectrique (300).

6. Générateur selon la revendication 5, dans lequel la seconde extrémité de l'antenne d'émission d'ondes électromagnétiques (600) est espacée de ou entre en contact avec la première portion d'extrémité du tube diélectrique (300).

7. Générateur selon la revendication 5, dans lequel une longueur entre les première et seconde extrémités de l'antenne d'émission d'ondes électromagnétiques (600) est au moins une moitié d'une largeur du connecteur creux (100), dans lequel la direction en largeur est parallèle à une direction d'extension de l'antenne d'émission d'ondes électromagnétiques (600) ; et
dans lequel la seconde extrémité de l'antenne d'émission d'ondes électromagnétiques (600) est espacée de ou entre en contact avec la première portion d'extrémité du tube diélectrique (300) ; et
dans lequel la première portion d'extrémité du tube diélectrique (300) est insérée dans le second espace interne de la chemise de refroidissement (500) ; ou
dans lequel la première portion d'extrémité du tube diélectrique (300) passe à travers une première extrémité latérale ouverte du connecteur creux (100) et dans le premier espace interne du connecteur creux (100).

8. Générateur selon la revendication 5, dans lequel une épaisseur ou un diamètre de l'antenne d'émission d'ondes électromagnétiques (600) sont plus petits qu'un diamètre interne du tube diélectrique (300).

9. Générateur selon la revendication 5, comprenant en outre un élément de transmission d'ondes électromagnétiques (700) disposé dans le premier espace interne,
dans lequel la première portion d'extrémité du tube diélectrique (300) passe à travers une première extrémité latérale ouverte du connecteur creux (100) et dans le premier espace interne du connecteur creux (100),
dans lequel la seconde extrémité de l'antenne d'émission d'ondes électromagnétiques (600) est insérée dans le premier espace interne du connecteur creux (100), dans lequel l'élément de transmission d'ondes électromagnétiques (700) entoure la première portion d'extrémité du tube diélectrique (300), et entoure la seconde extrémité de l'antenne d'émission d'ondes électromagnétiques (600).

10. Générateur selon la revendication 5, comprenant en outre :
un élément de transmission d'ondes électromagnétiques (700) disposé dans le premier espace interne ; et
une chemise de refroidissement (500) incluant un corps de tube creux présentant un second espace interne défini par une paroi entourante de celui-ci, dans lequel le tube diélectrique (300) est reçu dans le second espace interne ;
dans lequel la seconde extrémité de l'antenne d'émission d'ondes électromagnétiques (600) est insérée dans le premier espace interne du connecteur creux (100),
dans lequel la première portion d'extrémité du tube diélectrique (300) est reçue dans le second espace interne,
dans lequel l'élément de transmission d'ondes électromagnétiques (700) entre en contact avec la première portion d'extrémité du tube diélectrique (300), et entoure la seconde extrémité de l'antenne d'émission d'ondes électromagnétiques (600).

11. Générateur selon la revendication 5, comprenant en outre :
un élément de transmission d'ondes électromagnétiques (700) disposé dans le premier espace interne ; et
une chemise de refroidissement (500) incluant un corps de tube creux présentant un second espace interne défini par une paroi entourante de celui-ci, dans lequel le tube diélectrique (300) est reçu dans le second espace interne ;
dans lequel la seconde extrémité de l'antenne d'émission d'ondes électromagnétiques (600) passe à travers le premier espace interne du connecteur creux (100) et est insérée dans le second espace interne ;
dans lequel la première portion d'extrémité du tube diélectrique (300) est reçue dans le second espace interne,
dans lequel l'élément de transmission d'ondes électromagnétiques (700) est partiellement formé dans le second espace interne, dans lequel l'élément de transmission d'ondes électromagnétiques (700) entre en contact avec la première portion d'extrémité du tube diélectrique (300), et entoure la seconde extrémité de l'antenne d'émission d'ondes électromagnétiques (600).
